# EUROPÄISCHE PATENTSCHRIFT

(11) **EP 0 819 781 B1**
(45) Veröffentlichungstag und Bekanntmachung des Hinweises auf die Patenterteilung: **12.01.2000**
(21) Anmeldenummer: 97111408.7
(22) Anmeldetag: 05.07.1997
(51) Int. Cl.: C25D 17/00, H05K 3/24

(54) **Einrichtung zur Behandlung von Gegenständen insbesondere Galvanisiereinrichtung für Leiterplatten**
Apparatus for the treatment of objects, in particular galvanising apparatus for printed circuit boards
Installation de traitement des objets, en particulier installation de galvanisation pour plaques de circuit imprimé

(30) Priorität: 17.07.1996 DE 19628784
(43) Veröffentlichungstag der Anmeldung: 21.01.1998
(73) Patentinhaber: Gebr. Schmid GmbH & Co., D-72250 Freudenstadt (DE)
(72) Erfinder: Schmid, Dieter C., Dipl.-Ing., D-72250 Freudenstadt (DE)
(74) Vertreter: Patentanwälte Ruff, Beier, Schöndorf und Mütschele

(56) Entgegenhaltungen:
- WO-A-92/18669
- DE-A- 4 413 149

## Beschreibung

### Anwendungsgebiet und Stand der Technik

Die Erfindung betrifft eine Einrichtung zur Behandlung von Gegenständen, insbesondere eine Galvanisiereinrichtung für Leiterplatten, auf einer Durchlaufbahn durch eine Behandlungskammer, mit Transportmitteln für den Transport der Gegenstände durch ein Behandlungsmedium, wie eine Elektrolytlösung, und mit Kontaktiermitteln zur elektrischen Kontaktierung und Stromzuführung von einer Stromversorgung zu den Gegenständen.

Gemäß der DE-A-44 13 149 können die Kontaktiermittel mehrere, wenigstens zwei, elektrisch voneinander isolierte, im Behandlungsmedium umlaufende, elektrisch unterschiedlich kontaktierte Kontaktsektoren aufweisen. Bei der dort beschriebenen Ausführung sind sie in Umlaufrichtung abwechselnd kathodisch und anodisch an die Stromversorgung anschließbar. Dadurch ist es möglich, im kathodisch kontaktierten Bereich eine Stromzuführung zu den Gegenständen vorzunehmen. Die dabei sich zwangsläufig ergebende mehr oder weniger starke Metallisierung der Kontaktierungsflächen wird dann im anodisch beaufschlagten Bereich durch eine Hilfs- oder Entmetallisierungskathode entfernt.

Es ist ferner aus der DE-A-42 12 567 bekanntgeworden, die Gegenstände auf einer Transportbahn mittels Zangen zu erfassen, die gleichzeitig zum Transport und zur Kontaktierung dienen. Eine kathodische Kontaktierung über umlaufende Walzen, die außerhalb des Behandlungsmediums über Schleifringe mit Strom versorgt werden, ist aus der DE-A-42 12 567 bekannt. Diese sind an einem umlaufenden Transportsystem geführt, das die Kontaktrollen mit halber Transportgeschwindigkeit der Gegenstände durch die Behandlungskammer transportiert. Auf dem Rückweg werden die Kontaktrollen mit dem entgegengesetzten Pol (anodisch) kontaktiert, so daß vorher auf den Kontaktflächen abgeschiedenes Material (Kupfer) galvanisch wieder entfernt wird.

Aus der DE-A-25 26 006 ist ein Verfahren und eine Vorrichtung zum Elektroplattieren bekanntgeworden, bei der ein zu plattierendes Band um eine zur Hälfte in die Behandlungsflüssigkeit eingetauchte Walze herumgeführt wird. Diese Walze wird nur in dem Bereich mit Strom versorgt, der untergetaucht ist. Dazu ist die Walze mit voneinander elektrisch getrennten Segmenten versehen, die über einen Kollektor beaufschlagt werden. Damit soll eine Funkenbildung verhindert werden.

Es ist ferner aus der US-T-106 001 eine Vorrichtung zur Alkalisierung eines Subtrates bekanntgeworden, bei der das Substrat außerhalb einer Behandlungsflüssigkeit jeweils abwechselnd anodisch und kathodisch kontaktiert wird, und zwar mit zwei Walzen mit isolierten Kontaktsegmenten.

### Aufgabe und Lösung

Die Erfindung hat es sich zur Aufgabe gemacht, die Einrichtung nach der DE-A-44 13 149 in Bezug auf eine noch bessere und störungsfreie Kontaktierung weiter zu verbessern.

Zur Lösung dieser Aufgabe ist vorgesehen, daß die Kontaktsektoren in Umfangsrichtung einander zumindest teilweise überlappend ausgebildet sind. Sie können beispielsweise schräg bzw. stufenförmig verlaufende, elektrisch isolierende Trennlinien aufweisen. Auf diese Weise wird sichergestellt, daß keine Linienkontaktierung auftritt, d.h. schlagartig die gesamte Strombeaufschlagung über eine Linie erfolgt. Die Kontaktsektoren "übergeben" einander die Kontaktierung. Besonders wirkungsvoll wird dieses System, wenn durch die Stromeinleitung zu den Kontaktsektoren sichergestellt wird, daß sich die beiden überlappenden Kontaktsektoren sich im Moment der Kontaktierung mit dem Gegenstand auf dem gleichen Potential befinden. Die Kommutierung kann dann so erfolgen, daß im Kontaktbereich die einander überlappenden Kontaktsektoren an die Stromversorgung angeschlossen sind. Wenn also die überlappte Trennstelle zwischen den zwei aufeinanderfolgenden Kontaktsektoren den Gegenstand passiert, sind beide Kontaktsektoren gleichmäßig an die Stromversorgung angeschlossen, so daß keine Stromunterbrechung mit Funkenbildung oder dergleichen auftritt. Zwar ist normalerweise ein Gegenstand gleichzeitig von mehreren im Durchlauf aufeinanderfolgenden Kontaktwalzen oder Paaren von Kontaktwalzen kontaktiert, aber infolge der hohen Ströme und den teilweise sehr dünnen Kontaktschichten auf den Gegenständen kann es doch zu erheblichen Spannungsabfällen innerhalb eines Gegenstandes führen, so daß einzelne Kontaktstellen teilweise auf unterschiedlichem Potential liegen. Es wird in jedem Falle eine Funken- oder Lichtboqenbildung bei dem Durchlauf der Kontaktsegmente vermieden.

Die Stromeinleitung zu den Kontaktsektoren kann vorzugsweise nach Art von mit zahlreichen Sektoren versehenen Kollektoren oder Kommutatoren ausgebildet sein.

Die Aufgabe wird ferner vorteilhaft dadurch gelöst, daß die Kontaktiermittel in einer von der übrigen Behandlungskammer weitgehend abgetrennten, jedoch mit Behandlungsmedium gefüllten Kontaktierkammer angeordnet sind und vorzugsweise auf einen zur Kontaktierung vorgesehenen Galvanorand der Gegenstände einwirken. In diesem Falle brauchen also die zur Führung der Gegenstände auf ihrer Behandlungsbahn verwendeten Walzenpaare selbst nicht mit Kontaktflächen versehen zu sein. Dementsprechend findet in diesem Auftragsbereich überhaupt kein unerwünschter Galvano-Auftrag statt. Durch die Teil-Abschottung des Kontaktierbereiches wird der unerwünschte galvanische Auftrag auf die Kontaktiermittel schon wesentlich verringert, so daß die Aufgabe der Entmetallisierung dieser Bereiche erleichtert wird. Auch die Anordnung und sonstige Wirkungsweise der Entmetallisierung, die ebenfalls in dieser Kontaktierkammer stattfinden kann, wird durch die Teil-Abschottung verbessert.

Im Rahmen der Aufgabenlösung ist es vorteilhaft, wenn zwischen Kontaktiermitteln und Entmetallisierungskathode eine teildurchlässige Trennwand eingefügt ist. Diese kann eine mechanische Abschottung, d.h. ein zum Beispiel enges Sieb sein oder, bevorzugt, eine semipermeable, d.h. zumindest für die die Entmetallisierung bewirkenden Ionen durchlässige Membran sein.

Durch diese Teil-Abschottung der Entmetallisierungskathode wird vermieden, daß Metall, das sich an dieser in teilweise recht ungeordneter Form niederschlägt, abfällt und mit dem Behandlungsmedium herum transportiert wird. Dabei kann es sowohl bei der Kontaktierung der Gegenstände als auch auf dem Galvanoüberzug der Gegenstände sowie in den Transportsystemen Probleme machen, bevor es abgeschieden oder ausgefiltert wird. Die teildurchlässige Trennwand sorgt dafür, daß diese Metallpartikel oder -brocken in einem vom übrigen Behandlungsmedium getrennten Bereich bleiben und von dort entfernt werden können.

Die Entmetallisierung ist sehr wirkungsvoll und bringt viele Vorteile, weil sie auch lange Standzeiten der Anlage ohne zwischenzeitliche Wartung zur Reinigung der Kontaktierflächen etc. erlaubt. Bei etwas geringeren Anforderungen daran könnte aber die unerwünschte Aufmetallisierung der Kontaktierflächen auch dadurch verringert werden, daß der Stromfluß, eventuell durch in Umfangsrichtung sehr kurze Kontaktsektoren und entsprechend enge Kommutierung, der Anschluß an die Stromversorgung auf einen so kleinen Bereich beschränkt wird, daß die unerwünschte Metallisierung dieser Flächen verringert wird. Im Zusammenwirken mit den übrigen Maßnahmen, beispielsweise einer weitgehenden Abschottung der Kontaktierkammer etc., könnte gegenüber dem Stand der Technik bereits ein wesentlicher Erfolg ohne aktive Entmetallisierung erreicht werden.

Durch die Erfindung kann also eine Durchlauf-Galvanisieranlage geschaffen werden, bei der das Problem des unerwünschten Metallauftrages auf die Kontaktflächen vermieden ist, die bei einer abrollenden Kontaktierung des zu metallisierenden Gegenstandes zum Beispiel einer elektrischen Leiterplatte, auftritt. Dazu können auf Kontaktwalzen oder -scheiben einzelne Kontaktsektoren vorgesehen sein, die über einen außerhalb der Behandlungskammer liegenden Kommutator abwechselnd anodisch und kathodisch strombeaufschlagt werden. Wenn diese einander überlappend, beispielsweise schräg, pfeilförmig oder stufenförmig versetzt angeordnet sind, kann eine übergangslose Kontaktierung zum Gegenstand sichergestellt werden. Die Kontaktierung kann in einem seitlichen Abschnitt der Behandlungskammer erfolgen, der zwar mit der Behandlungsflüssigkeit gefüllt, jedoch weitgehend dieser gegenüber abgeschirmt ist, so daß die Tendenz zum Metallauftrag verringert wird. Eine teildurchlässige Trennwand kann insbesondere die Kontaktflächen davor schützen, durch von der Hilfskathode zur Entmetallisierung abgelösten Partikeln verunreinigt zu werden.

Wie sich aus den Ansprüchen, der bisherigen Beschreibungseinleitung und den noch folgenden Ausführungen ergibt, ist die Anwendung der Erfindung nicht auf das Abscheiden von Metallen aus dem Elektrolyten auf die Gegenstände beschränkt. Bei entsprechender Umkehrung der Polarität kann die erfindungsgemäße Einrichtung auch zum Metallabtrag, d.h. zum Übertritt von Metallionen in den Elektrolyten, sowie zum elektrolytischen Entfetten eingesetzt werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

In den Zeichnungen sind Ausführungsbeispiele der Erfindung dargestellt und werden im folgenden näher erläutert. Es zeigen:
- Fig. 1: ein schematischer Teilquerschnitt durch eine Galvanisiereinrichtung,
- Fig. 2 und 3: Details der Oberfläche von Kontaktiermitteln, und
- Fig. 4: einen Kommutator zur Stromeinleitung in die Kontaktiermittel.

### Beschreibung eines bevorzugten Ausführungsbeispiels

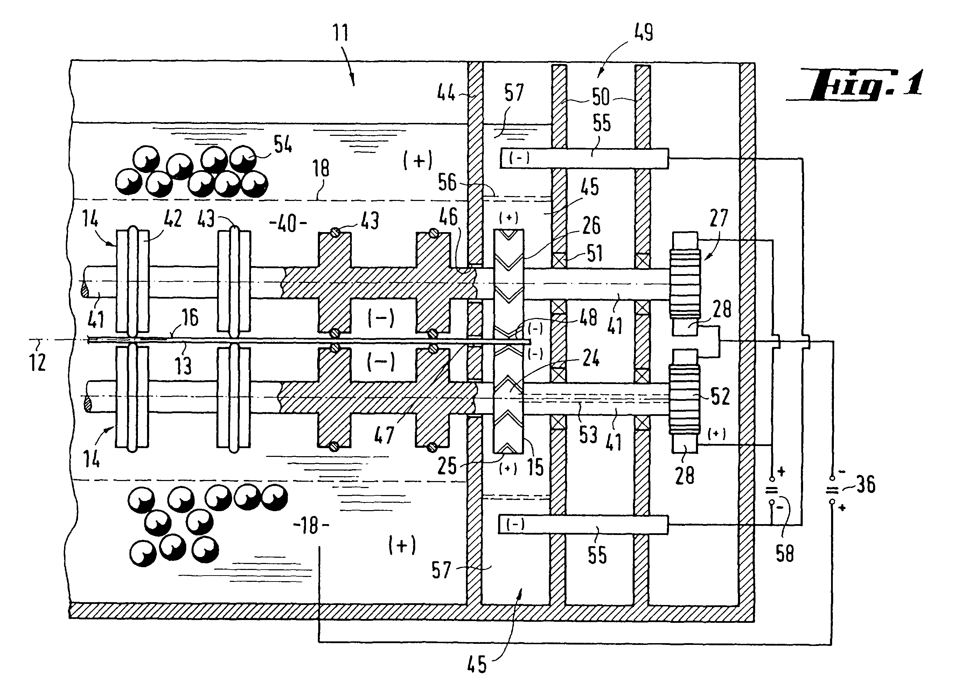

Fig. 1 zeigt schematisch einen Teil einer Galvanisiereinrichtung mit einer Behandlungskammer 11, die mit einem Behandlungsmedium 40, beispielsweise einer Elektrolytlösung, gefüllt ist. In der langgestreckten Behandlungskammer ist eine meist horizontale Durchlaufbahn 12 (senkrecht zur Zeichenebene) für zu behandelnde Gegenstände 13, beispielsweise elektrische Leiterplatten, ausgebildet. Sie werden auf der Durchlaufbahn horizontal liegend durch die Behandlungskammer 11 gefördert. Die Durchlaufbahn 12 wird von Transportmitteln 14 in Form von Transportwalzen oder -rädern gebildet, die im vorliegenden Fall als von einer Kunststoffwelle 41 vorstehende Scheiben 42 gebildet sind. Sie stehen sich jeweils paarweise gegenüber und kontaktieren die Gegenstände 13 mittels eines elastischen, umlaufenden Vorsprunges, der im Ausführungsbeispiel als in eine Nut der Scheibe 42 eingelegter O-Ring 43 ausgebildet ist.

Die Gegenstände 13 sind mit einer elektrisch leitenden Schicht 16 überzogen. Diese ist zum Beispiel als Kupferkaschierung auf dem Basismaterial des Gegenstandes vorhanden. Die Innenfläche von in den Gegenständen vorgesehenen Bohrungen wurden vorher zum Beispiel durch chemische Metallabscheidung elektrisch leitfähig gemacht. Die elektrisch leitende Schicht auf den Gegenständen und in deren Bohrungen kann auch aus einem elektrisch leitenden Polymer, beispielsweise einem entsprechenden Kunststoff, oder aus Graphit oder ähnlichem bestehen.

Die Wellen 41 der in kurzen Abständen paarweise oberhalb und unterhalb der Durchlaufbahn angeordneten, gegenläufig angetriebenen Transportmittel 14 ragen durch eine Trennwand 44 hindurch, die eine Kontaktierkammer 45 von der übrigen Behandlungskammer 11 weitgehend abtrennt. Sie ist jedoch mit dieser durch die Durchgangsöffnungen 46 für die Wellen 41 und durch einen Längsschlitz 47 mit dieser verbunden, durch den der Gegenstand 13 bis in die Kontaktierkammer hineinragt.

In dem in der Kontaktierkammer 44 verlaufenden Randbereich hat der Gegenstand 13 einen sogenannten Galvanorand 48, d.h. einen Bereich, der hauptsächlich zur durchgehenden Kontaktierung während der Galvanisierung vorgesehen ist.

Die Kontaktierkammer 45 ist nach außen hin durch einen Abdichtbereich 49 abgeschlossen, zu dem beispielsweise zwei Zwischenwände 50 gehören, durch die die Wellen 41 weitgehend abgedichtet hindurchragen. In diesem Bereich kann sich auch der Antrieb der Transportmittel 14 befinden, beispielsweise in Form von Kegelrädern, die von einer gemeinsamen Achse aus angetrieben sind. Sie sind hier zur Vereinfachung der Darstellung nicht gezeigt, ebensowenig die Abdichtungssysteme, die zum Beispiel nach Art eines Labyrinthes arbeiten können, in der Zeichnung jedoch nur als Elemente 51 schematisch gezeigt sind.

Angrenzend an den Abdichtbereich ist auf jeder Welle 41 ein Stromzuleitmittel 27 nach Art eines Kommutators angeordnet, der von Stromzuleitungen 28 nach Art von Kollektorbürsten beaufschlagt wird.

Die einzelnen Kommutatorsektoren 52 sind mit Kontaktsektoren 24 auf Kontaktiermitteln 15 elektrisch verbunden, beispielsweise durch unter einer Kunststoffhülse verdeckt verlaufende Leiterschienen 53 in der Welle 41. Die Kontaktiermittel 15 bestehen aus je einer auf der Welle 41 angeordneten Scheibe, so daß sich zwei dieser Scheiben paarweise gegenüberstehen und den Galvanorand 48 beidseitig berühren und mit ihren Kontaktflächen 25 kontaktieren. Die Kontaktiermittel 15 sind in der Kontaktierkammer 45 vorgesehen und somit weitgehend von der Behandlungskammer 11 getrennt, in der in anodisch angeschlossenen Anodenkörben 18 das galvanisch aufzubringende Metall in Form von Kugeln 54, beispielsweise Kupferkugeln, liegt.

Die Kontaktsektoren oder -segmente 24 sind so ausgebildet, daß sich zwei benachbarte Sektoren überlappen, indem der zwischen den Sektoren vorgesehene Isoliersektor 26 schräg zur Wellenachse erstreckt, im Beispiel nach Fig. 1 V-förmig. Die Zahl der Kommutatorsektoren 52 kann der der Kontaktsektoren 24 entsprechen, es ist jedoch auch eine unterschiedliche Teilung bei beiden möglich, wenn die Anschlüsse teilweise zusammengelegt sind.

In der Kontaktierkammer 45 sind Hilfs- oder Entmetallisierungskathoden 55 so vorgesehen, daß sie möglichst benachbart zu den vom Gegenstand 13 abgewandten Abschnitten der Kontaktmittel 7 sind. Zwischen den Entmetallisierungskathoden 55 und der Oberfläche 25 der Kontaktmittel ist hier eine teilweise durchlässige Trennwand 56 vorgesehen. Sie kann beispielsweise aus einer semipermeablen Membran bestehen, beispielsweise aus Polypropylen oder anderen von sich aus oder durch entsprechende Behandlung semipermeabel gemachten, mechanisch relativ stabilen Membranen. Diese lassen zwar den Stromfluß und die Ionenwanderung von der Oberfläche 24 zur Kathode 55 zu, hindern aber Partikel, die sich auf der Kathode 55 gebildet und von dieser abgelöst haben, daran, in das Behandlungsmedium 40 außerhalb des durch die teildurchlässigen Trennwände 56 abgeschirmten Entmetallisierungsbereiches 57 zu gelangen.

### Funktion

Die von den Transportmitteln 14 waagerecht durch die mit Behandlungsmedium 40 gefüllte Behandlungskammer 11 geführten Gegenstände 13 werden von den gegenläufig angetriebenen Transportmitteln transportiert und gleichzeitig an ihrer Oberflächenschicht von den Kontaktsektoren 24 der Kontaktiermittel 15 kontaktiert.

Diese stehen jeweils in dem dem Gegenstand 13 nahen Abschnitt mit dem Minuspol einer Stromversorgung 36 in Kontakt, was durch die nach Art von Kohlebürsten oder dergleichen ausgebildeten Stromversorgungen 28 zu den zugehörigen Kommutatorsektoren 52 gesteuert wird. In den vom Gegenstand 13 abgewandten Bereichen stehen die Kontaktsektoren 24, ebenfalls über entsprechende Kommutatorsektoren 52 und Stromzuleitungen 28, mit dem Pluspol einer Entmetallisierungs-Stromversorgung 58 in Verbindung. Der Pluspol der Galvanisierungs-Stromversorgung 36 ist mit den Anodenkörben 18 verbunden und der Minuspol der Entmetallisierungs-Stromversorgung 58 mit den Entmetallisierungskathoden.

Auf der Oberfläche des Gegenstandes 16 und in gewissem Maße auch auf den Kontaktsektoren, soweit diese kathodisch angeschlossen sind, wird Metall aus dem Elektrolyten abgeschieden, während von den in den Anoden befindlichen Metallkugeln 54 gleichzeitig Metallionen in den Elektrolyten übergehen, diese sich also "auflösen". Gleichzeitig ist jedoch in dem vom Gegenstand 13 entfernten Bereich ein Teil der Kontaktsektoren 24 ebenfalls anodisch angeschlossen, so daß auch von den Kontaktflächen 25 unerwünschtes Metall in den Elektrolyten übergeht und zwar dasjenige, das vorher bei kathodischer Kontaktierung darauf abgeschieden war. Diese Flächen werden also stets und unmittelbar anschließend an ihre unerwünschte Metallisierung wieder entmetallisiert. Durch entsprechende Wahl des Werkstoffes der Kontaktsektoren, zum Beispiel Graphit, Edelstahl, Titan, Platin oder dergleichen, kann ein Abtrag der Kontaktsektoren selbst verhindert werden. Es ist also zu erkennen, daß die infolge des Gesamtaufbaus der Einrichtung zwar geringe, aber nicht gänzlich vermeidbare galvanische Metallisierung der Kontaktierflächen unmittelbar anschließend wieder entfernt wird.

Bei der Entmetallisierung wandern die Metallionen unter dem Einfluß des von der Entmetallisierungs-Stromversorgung 58 angelegten Stromes durch die halbdurchlässige Trennwand 56. Auf der Entmetallisierungskathode 55 bildet sich ein Metallbelag, der häufig nicht gleichmäßig, sondern in Form eines "Wildwuchses" auftritt. Wenn sich Metallteile davon ablösen, so verbleiben sie in dem von den Trennwänden 56 abgeschirmten Bereich 57. Dieser ist, wie die gesamte Behandlungskammer, bis über die Anoden 18 und die Kathode 55 mit Behandlungsflüssigkeit gefüllt.

### Weitere Ausführungsformen

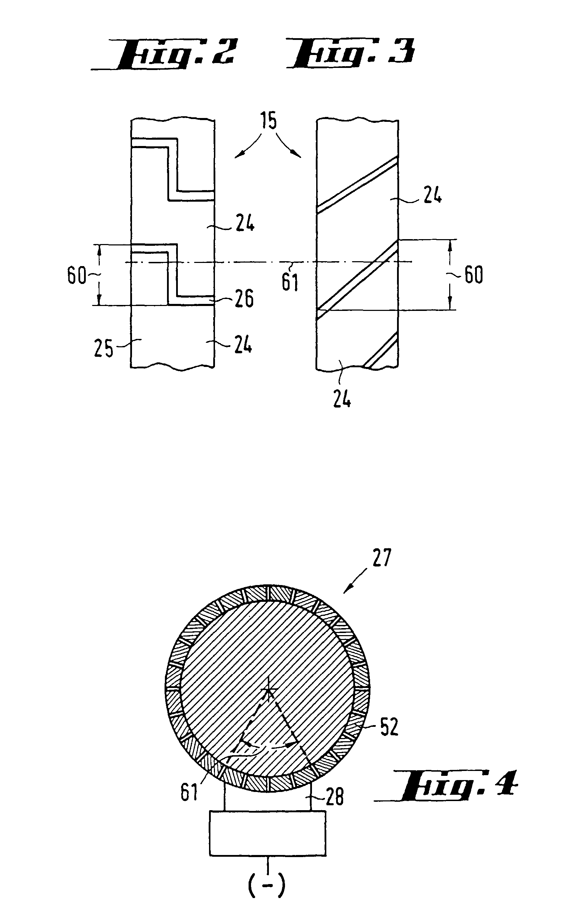

Fig. 2 zeigt einen Abschnitt der Umfangsfläche 25 der Kontaktiermittel 15. Die darauf ausgebildeten Kontaktsektoren 24 sind jeweils ineinandergreifend Z-förmig ausgebildet, indem sie durch ebenfalls Z-förmig ausgebildete Isoliersektoren 26 voneinander getrennt sind. Es bildet sich somit ein Überlappungsbereich 60, in dem jeweils aneinander angrenzende Sektoren 24 gleichzeitig den Gegenstand kontaktieren können.

Entsprechendes gilt für Fig. 3, wo die Isoliersektoren 26 in Form von schräg zur Achsrichtung 61 verlaufenden Streifen ausgebildet sind, so daß auch die Kontaktsektoren 24 rhombenförmig ausgebildet sind und sich ein Überlappungsbereich 60 bildet. Die Kontaktsektoren können also in Umfangsrichtung beliebige und ggf. auch gekrümmte Begrenzungen haben, um die gewünschte, auch in der Ausführung nach Fig. 1 erreichte überlappende Kontaktierung zu erreichen.

Fig. 4 zeigt die Stromeinleitmittel 27 in Form eines Kommutators mit relativ vielen Kommutatorsektoren 52, die von den Stromeinleitmitteln 28, die nach Art von Kohlebürsten ausgebildet sind, nur in einem relativ kleinen Winkelbereich 61 kontaktiert sind. Dieser Bereich sollte in Abhängigkeit von der Größe der Kommutatorsektoren und dementsprechend auch den entsprechend fein gegliederten Kontaktsektoren 24 an den Kontaktmitteln so gewählt werden, daß er weitgehend auf die Berührungszone der Kontaktsektoren 24 am Gegenstand 13 beschränkt ist. Die übrigen Bereiche der Kontaktsektoren 24 sind dementsprechend stromlos und neigen auch nicht dazu, sich selbst zu metallisieren. Dazu trägt auch die Anordnung der Kontaktiermittel 15 in der weitgehend abgeschirmten Kontaktierkammer bei.

## Patentansprüche

1. Einrichtung zur Behandlung von Gegenständen (13), insbesondere Galvanisiereinrichtung für Leiterplatten, auf einer Durchlaufbahn (12) durch eine Behandlungskammer (11), mit Transportmitteln (14) für den Transport der Gegenstände (13) durch ein Behandlungsmedium, wie eine Elektrolytlösung, und mit Kontaktiermitteln (15) zur elektrischen Kontaktierung und Stromzuführung von einer Stromversorgung (36) zu den Gegenständen (13), wobei die Kontaktiermittel (15) mehrere, wenigstens zwei, elektrisch voneinander isolierte, im Behandlungsmedium (40) umlaufende, elektrisch unterschiedlich kontaktierte Kontaktsektoren (24) aufweisen, dadurch gekennzeichnet, daß die Kontaktsektoren (24) in Umfangsrichtung einander zumindest teilweise überlappend ausgebildet sind.

2. Einrichtung nach Anspruch 1, dadurch gekennzeichnet, daß die Kontaktsektoren schräg bzw. stufenförmig verlaufende, die Kontaktsektoren voneinander elektrisch trennende Isoliersektoren (26) aufweisen.

3. Einrichtung nach Anspruch 1 oder 2, dadurch gekennzeichnet, daß die Stromeinleitung zu den Kontaktsektoren (24) derart ausgebildet ist, daß im Kontaktierbereich die einander überlappenden Kontaktsektoren (24) an die Stromversorgung angeschlossen sind.

4. Einrichtung nach einem der vorhergehenden Ansprüche, dadurch gekennzeichnet, daß die Stromeinleitung zu den Kontaktsektoren (24) nach Art von mit zahlreichen Kommutatorsektoren (52) versehenen Kommutatoren (27) ausgebildet ist.

5. Einrichtung nach einem der vorhergehenden Ansprüche, dadurch gekennzeichnet, daß nicht in Kontakt mit den Gegenständen (13) stehende Kontaktsektoren (24) an eine der Polarität der Gegenstände (13) entgegengesetzter Polarität angeschlossen sind und mit einer Entmetallisierungskathode (55) zur Entmetallisierung der Kontaktsektoren (24) zusammenwirken.

6. Einrichtung, insbesondere nach einem der vorhergehenden Ansprüche, dadurch gekennzeichnet, daß zwischen Kontaktiermitteln (15) und Entmetallisierungskathode (55) eine teildurchlässige Trennwand (56) eingefügt ist.

7. Einrichtung nach Anspruch 6, dadurch gekennzeichnet, daß die Trennwand (56) eine zumindest für Ionen durchlässige Membran ist.

8. Einrichtung nach dem Oberbegriff des Anspruchs 1, dadurch gekennzeichnet, daß die Kontaktiermittel (15) in einer von der übrigen Behandlungskammer (11) weitgehend abgetrennten, jedoch mit Behandlungsmedium (40) gefüllten Kontaktierkammer (45) angeordnet sind und vorzugsweise auf einen zur Kontaktierung vorgesehenen Galvanorand (48) der Gegenstände (13) einwirken.

9. Einrichtung nach dem Oberbegriff des Anspruchs 1, dadurch gekennzeichnet, daß im wesentlichen nur diejenigen Kontaktsektoren (24) an die Stromversorgung (36) angeschlossen sind, die die Gegenstände (13) kontaktieren.

## Claims

1. Apparatus for the treatment of articles (13), particularly a galvanizing apparatus for printed circuit boards, on a continuous path (12) through a treatment chamber (11), with conveying means (14) for conveying the articles (13) through a treatment medium, such as an electrolytic solution, and with contacting means (15) for the electrical contacting and power feeding from a power supply (36) to the articles (13), the contacting means (15) having several, at least two, mutually electrically insulated, electrically differently contacted contact sectors (24) circulating in the treatment medium (40), characterized in that the contact sectors (24) are arranged in an at least partly overlapping manner in the circumferential direction.

2. Apparatus according to claim 1, characterized in that the contact sectors have insulating sectors (26) electrically separating the contact sectors from one another and having a sloping or step-like configuration.

3. Apparatus according to claim 1 or 2, characterized in that the power introduction to the contact sectors (24) is such that in the contacting area the mutually overlapping contact sectors (24) are connected to the power supply.

4. Apparatus according to one of the preceding claims, characterized in that the power introduction to the contact sectors (24) is in the form of commutators (27) provided with numerous commutator sectors (52).

5. Apparatus according to one of the preceding claims, characterized in that contact sectors (24) not in contact with tile articles (13) are connected to a polarity opposite to that of the articles (13) and cooperate with a deplating cathode (55) for deplating the contact sectors (24).

6. Apparatus, particularly according to one of the preceding claims, characterized in that a partly permeable partition (56) is introduced between the contacting means (15) and deplating cathode (55).

7. Apparatus according to claim 6, characterized in that the partition (56) is a membrane at least permeable for ions.

8. Apparatus according to the preamble of claim 1, characterized in that the contacting means (15) are placed in a contacting chamber (45) largely separated from the remaining treatment chamber (11), but filled with treatment medium (40) and preferably act on a galvano-edge (48) of the articles (13) provided for contacting purposes.

9. Apparatus according to the preamble of claim 1, characterized in that substantially only those contact sectors (24) are connected to the power supply (36) which contact the articles (13).

## Revendications

1. Installation de traitement d'objets (13), en particulier installation de galvanisation pour plaques de circuits imprimés, sur une voie de passage (12) à travers une chambre de traitement (11), avec des moyens de transport (14) pour le transport des objets (13) à travers un milieu de traitement tel qu'une solution d'électrolyte, et avec des moyens de mise en contact (15) pour la mise en contact électrique et l'amenée de courant provenant d'une alimentation en courant (36) aux objets (13), les moyens de mise en contact (15) comportant plusieurs segments de contact (24), au moins deux, électriquement isolés les uns des autres et traversant le milieu de traitement (40) et contactés électriquement de façon différente, caractérisée en ce que les segments de contact (24) sont conçus de façon à se chevaucher les uns les autres au moins partiellement dans la direction périphérique.

2. Installation selon la revendication 1, caractérisée en ce que les segments de contact comportent des segments isolants (26) s'étendant en biais ou, selon les cas, en gradins, et séparant électriquement les segments de contact entre eux.

3. Installation selon la revendication 1 ou 2, caractérisée en ce que l'amenée du courant aux segments de contact (24) est conçue de telle sorte que, dans la zone de mise en contact, les segments de contact (24) se chevauchant les uns les autres sont connectés à l'alimentation en courant.

4. Installation selon l'une des revendications précédentes, caractérisée en ce que l'amenée du courant aux segments de contact (24) est conçue selon le type de commutateurs (27) dotés de nombreux segments de commutateur (52).

5. Installation selon l'une des revendications précédentes, caractérisée en ce que les segments de contact (24) qui ne sont pas en contact avec les objets (13) sont connectés à une polarité opposée à la polarité des objets (13) et en ce qu'ils agissent conjointement avec une cathode de démétallisation (55) pour démétalliser les segments de contact (24).

6. Installation, en particulier selon l'une des revendications précédentes, caractérisée en ce qu'une cloison (56) partiellement perméable est encastrée entre les moyens de mise en contact (15) et la cathode de démétallisation (55).

7. Installation selon la revendication 6, caractérisée en ce que la cloison (56) est une membrane au moins perméable aux ions.

8. Installation selon le préambule de la revendication 1, caractérisée en ce que les moyens de mise en contact (15) sont placés dans une chambre de contact (45) en grande partie séparée de l'autre chambre de traitement (11) mais remplie de milieu de traitement (40), et en ce qu'ils exercent une action de préférence sur un bord de galvanisation (48) des objets (13) prévu pour établir le contact.

9. Installation selon le préambule de la revendication 1, caractérisée en ce qu'essentiellement seuls sont connectés à l'alimentation en courant (36) les segments de contact (24) qui sont en contact avec les objets (13).
